# EUROPÄISCHE PATENTANMELDUNG

(11) **EP 4 345 466 A1**
(43) Veröffentlichungstag der Anmeldung: **03.04.2024**
(21) Anmeldenummer: 22198080.8
(22) Anmeldetag: 27.09.2022
(51) Int. Cl.: G01R 19/165

(54) **STEUERGERÄT UND VERFAHREN ZUR ÜBERWACHUNG EINES VERBRAUCHERS**

(71) Anmelder: NMH GmbH, 88367 Hohentengen (DE); ShoCoo GmbH, 88348 Bad Saulgau (DE)
(72) Erfinder: Bulander, Christian, 88348 Bad Saulgau (DE); Friedmann, Gabriel, 88518 Herbertingen (DE)
(74) Vertreter: Christ, Niko

(57) **Zusammenfassung**

In der Industrie wird der sinnvolle und sparsame Umgang mit Energie zunehmend wichtig. Dies liegt zum Einen an den Folgen unnötig verbrauchter Energie in der Umwelt und den insoweit auch unterdessen existierenden, restriktiven Auflagen, zum anderen auch an den mit dem Energieverbrauch verbundenen, hohen Kosten. Verpflichtend wird in Zukunft auch die Ermittlung eines so genannten CO₂-Footprints, also eine Bestimmung des im Zusammenhang mit einer Herstellung, einer Nutzung oder eines Verbrauchs eines Produkts freigesetzten CO₂-Betrags. Da die Arten der im Zusammenhang etwa mit der Herstellung eines Produkts verbrauchten Energie und Betriebsmittel vielfältig sind, ist die Bestimmung des CO₂-Footprints nur mit erheblichem Aufwand möglich und erfordert enorme Fachkenntnis und umfangreiche Installationen und Auswertungen von Messinstrumenten.

Die vorliegende Erfindung vereinfacht dies, indem sie eine Steuerung mit den erforderlichen Schnittstellen in einem Gehäuse vereint und eine Auswertung und Verknüpfung verschiedener Messergebnisse ermöglicht. Neben der Bestimmung des CO₂-Footprints dient die Erfindung auch zu dessen Verbesserung, indem in Abhängigkeit von den Messungen auch auf das Verhalten des überwachten Verbrauchers eingewirkt werden kann.

## Beschreibung

Die vorliegende Erfindung betrifft ein Steuergerät und ein Verfahren zur Überwachung eines Verbrauchers und zur Ermittlung eines CO₂-Footprints.

Eine der großen Herausforderungen an die Industrie ist die Herstellung von Produkten mit möglichst geringem Betriebsmitteleinsatz. Insbesondere ist es für die Industrie bedeutsam, den Ausstoß von CO₂ zu minimieren, da künftig aufgrund staatlicher Vorgaben ein so genannter CO₂-Footprint ermittelt und im Zusammenhang mit dem jeweiligen Produkt angegeben werden muss.

Der CO2-Footprint ist ein Maß für den Gesamtbetrag von CO2-Emissionen, welche direkt oder indirekt durch Aktivitäten oder Lebensstadien von Produkten entstehen oder verursacht werden. Hierbei können auch andere Treibhausgase und sonstiger Energieverbrauch quantisiert werden, wobei diese zu einem gleichwirkenden Verbrauch von CO₂ in ein Verhältnis gesetzt wird.

Um mit derzeitigen Mitteln einen Überblick über die zur Herstellung eines Produkts erforderliche Energie erhalten zu können, ist es notwendig, einer Produktionsmaschine, einer Bearbeitungsmaschine oder allgemein einem in diesem Zusammenhang zu betrachtenden Verbraucher mehrere Messinstrumente zuzuordnen und diese Messinstrumente auszuwerten, sowie die Auswertungen miteinander zu verknüpfen und Ableitungen daraus zu ziehen. Selbst bei einem derart großen Aufwand besteht dann lediglich die Möglichkeit, Daten zu sammeln und daraus einen nicht beeinflussbaren Wert zu ermitteln. Ziel der Industrie ist es jedoch, den CO₂-Footprint nicht nur zu ermitteln, sondern auch zu optimieren. Dies gelingt in diesem Zusammenhang nur durch grundsätzliche Änderungen. Ein Eingriff in die Prozesse ist nicht ohne Weiteres möglich.

Vor diesem Hintergrund liegt der vorliegenden Erfindung die Aufgabe zu Grunde, ein Steuergerät und ein Verfahren zur Überwachung eines Verbrauchers und zur Ermittlung eines CO₂-Footprints zu schaffen, mit denen eine umfassende Ermittlung verschiedener einzubeziehender Parameter ebenso möglich ist, wie eine Einwirkung zur Optimierung des CO₂-Footprints.Dies soll insbesondere auch mit wenig Aufwand an ungeschultem Personal möglich sein.

Gelöst wird diese Aufgabe durch ein Steuergerät zur Überwachung eines Verbrauchers und zur Ermittlung eines CO₂-Footprints gemäß den Merkmalen des unabhängigen Anspruchs 1, sowie durch ein entsprechendes Verfahren gemäß den Merkmalen des nebengeordneten Anspruchs 11. Sinnvolle Ausgestaltungen sowohl des Steuergeräts als auch des Verfahrens können den sich jeweils anschließenden abhängigen Ansprüchen entnommen werden.

Erfindungsgemäß vorgesehen ist ein Steuergerät zur Überwachung eines Verbrauchers und zur Ermittlung eines CO₂-Footprints, umfassend eine Mikroprozessoreinheit zur Erfassung und Verarbeitung von Messdaten, welche mit wenigstens einem Interface datenverbunden ist, wobei das Interface mehrere Schnittstellen zur Erhebung von Messdaten aufweist, welche mit dem Verbraucher verbindbar sind und welche Sensoren zur qualitativen und quantitativen Erfassung eines Energieverbrauchs des Verbrauchers, sowie Aktoren zur Einwirkung auf den Energieverbrauch des Verbrauchers aufweisen, und wobei der Mikroprozessoreinheit eine Auswerteeinheit zur Berechnung eines Energieverbrauchs während einer Betriebsphase des Verbrauchers zugeordnet ist.

Entsprechend vorgesehen ist erfindungsgemäß ein Verfahren zur Überwachung eines Verbrauchers und zur Ermittlung eines CO₂-Footprints, vermittels eines Steuergeräts mit einer Mikroprozessoreinheit, welche Messdaten erfasst und verarbeitet, welche von wenigstens einem mit der Mikroprozessoreinheit datenverbundenen Interface bereitgestellt werden, wobei das Interface mehrere Schnittstellen aufweist, welche über Sensoren und Aktoren mit dem Verbraucher verbunden werden, die Sensoren einen Energieverbrauch des Verbrauchers qualitativ und quantitativ erfassen und die Aktoren auf den Energieverbrauch des Verbrauchers einwirken und wobei die Mikroprozessoreinheit anhand von den Sensoren erfasster Daten mithilfe einer Auswerteeinheit einen Energieverbrauch während einer Betriebsphase des Verbrauchers berechnet.

Ziel eines solchen Steuergeräts und eines entsprechenden Verfahrens ist es, ein umfassendes Bild des Energieverbrauchs des Verbrauchers zu erhalten und auf diesen Verbrauch gegebenenfalls auch positiv einwirken zu können. Zentrales Element hierbei ist eine Mikroprozessoreinheit, welche die anfallenden Daten verarbeiten und miteinander in Bezug setzen kann. Die Datenerfassung erfolgt von einem Interface aus über verschiedene Schnittstellen, welchen geeignete Sensoren zugeordnet sind. Die Sensoren ermitteln sowohl Betriebsdaten als auch Verbrauchsdaten des Verbrauchers. Mit der entsprechenden Auswertung bei dem Mikroprozessor kann aufgrund einer Messung festgestellt werden, ob der Verbraucher zu einem bestimmten Zeitpunkt im Standby oder aktiv ist, gegebenenfalls in welchem Betriebszustand er sich befindet oder ob er etwa im Leerlauf ist und abgeschaltet werden könnte. Weiter kann es vorgesehen sein, dass die Mikroprozessoreinheit auf interne oder externe Datenbanken zugreifen kann, um von dort Nutzungspläne, Einbuchungen, Abläufe, Einstellungen und dergleichen mehr abzurufen, um weitere Informationen über den Betrieb des Verbrauchers zu erhalten.

Aus all diesen Daten und Messwerten kann die Mikroprozessoreinheit zum Einen ableiten, welcher Energieverbrauch an verschiedenen Stellen während einer Betriebsphase des Verbrauchers angefallen ist und welcher CO₂-Footprint sich letztlich daraus ergibt, er kann aber auch erkennen, ob ein Verbraucher sich aufgrund eines Ablaufplans und der Folgeplanungen in einer Betriebsphase befindet, in der er zum Energiesparen in den Standby-Modus geschaltet oder ganz außer Betrieb gesetzt werden kann. Hierzu wird die Mikroprozessoreinheit etwa auch Anlaufzeiten und Energieaufwand für das Stillsetzen und Anfahren des Verbrauchers berücksichtigen.

In konkreter Ausgestaltung eines solchen Steuergeräts kann es vorgesehen sein, dass die Sensoren wenigstens eine elektrische Messspule umfassen, welche an eine Stromleitung des Verbrauchers anschließbar ist und mit welcher Ströme und/oder Spannungen und/oder eine Netzfrequenz und/oder eine Leistung und/oder eine Blindleistung und/oder eine Scheinleistung und/oder eine Phasenverschiebung und/oder aus diesen abgeleitete Größen erfasst sind.

Eine solche Messspule kann mit besonderem Vorteil als eine Strommesszange ausgestaltet sein, welche um eine Versorgungsleitung des Verbrauchers angelegt wird. Verläuft die Versorgungsleitung nach dem Schluss der Strommesszange durch den ringförmig geschlossenen, weichmagnetischen Spulenkern hindurch, so können mit der auf einem Abschnitt des Spulenkerns gewickelten Messspule verschiedene Größen gemessen und aus diesen Messungen abgeleitet werden. Aufgrund der möglichen Gestaltung der Sensoren in der Art von Strommesszangen, welche mit dem Interface verbunden sind, kann die Installation unproblematisch durch instruiertes, aber nicht notwendigerweise aufwändig ausgebildetes Personal vorgenommen werden.

Bevorzugtermaßen kann vorgesehen sein, dass über ein Netzteil eine Stromversorgung hergestellt ist, wobei die Stromquelle eine Anschlussklemme des Verbrauchers ist.. Es erübrigt sich hierdurch, eine separate Versorgungsleitung bereitzustellen, über welche das Steuergerät versorgt wird. Vielmehr kann es ausreichend sein, wenn ohnehin der Stromverbrauch des Verbrauchers mithilfe von Strommesszangen erfasst wird, über die Strommesszangen auch eine Versorgungsspannung für das Steuergerät abzugreifen.

Ferner können verschiedene weitere Sensoren über entsprechende Schnittstellen mit dem Interface verbunden werden. Entsprechend kann vorgesehen sein, dass die Sensoren wenigstens einen Druckluftsensor umfassen, welcher in eine Druckluftleitung des Verbrauchers aufgenommen ist und welcher einen Durchfluss und/oder einen Druck und/oder eine Temperatur von in der Druckluftleitung geführter Druckluft erfasst. Im Gegensatz zur Erfassung von elektrischem Strom reicht bei Medien wie Druckluft, die ebenfalls ein Arbeitsmedium und damit einen Energieträger darstellt, ein Umgreifen der Leitung nicht aus. Hier ist es erforderlich, die Sensorik in die Leitung einzuarbeiten. Ähnlich wie im Fall von elektrischem Strom kann die Auswerteeinheit bereits aus dem Anliegen oder Nichtanliegen eines Drucks in der Druckluftleitung erste Rückschlüsse auf eine Betriebsphase des Verbrauchers ziehen.

Ebenfalls kann vorgesehen sein, dass die Sensoren wenigstens einen Temperatursensor umfassen, welcher im Bereich oder in Kontakt mit dem Verbraucher angeordnet ist. Sowohl eine Umgebungstemperatur als auch eine Oberflächentemperatur kann für den Arbeitsprozess von Interesse sein und je nach Anwendung kann es erforderlich sein, mit geeigneten Maßnahmen auf die Einhaltung entsprechender Temperaturvorgaben einzuwirken.

Weiter kann vorgesehen sein, dass die Sensoren wenigstens einen Kühlwassersensor umfassen, welcher in eine Kühlwasserleitung des Verbrauchers aufgenommen ist und welcher einen Durchfluss und/oder eine Temperatur von in der Kühlwasserleitung geführtem Kühlwasser erfasst. Speziell die Temperatur des Kühlwassers kann ein guter Indikator für eine Betriebsphase des Verbrauchers sein. Hierbei ist allerdings zu beachten, dass das Kühlwasser eher träge auf Veränderungen in der Betriebsphase reagiert.

In konkreter Ausgestaltung können die Sensoren wenigstens einen Füllstandssensor umfassen, welcher einem Medienbehälter des Verbrauchers zugeordnet ist. Dies kommt insbesondere für Medienbehälter infrage, die Betriebsmittel des Verbrauchers wie Kühlwasser, Hydrauliköl oder dergleichen enthalten, jedoch auch für Lagerbestände an Werkstücken oder Material zur Verarbeitung. Neben der Möglichkeit, aufgrund niedriger Füllstände einen Alarm zum Nachfüllen des Bestandes auszugeben, kann auch bei Ausbleiben der Nachfüllung eine Stillsetzung des Verbrauchers geplant werden.

In weiterer Ausgestaltung können die Aktoren mit schaltbaren Ausgängen des Interface verbunden sein, wobei eine Abschaltung des Verbrauchers in Reaktion auf eine Berechnung eines Energieverbrauchs oder in Reaktion auf eine Feststellung eines Verbrauchsverhaltens des Verbrauchers ausgelöst ist. Ein solcher schaltbarer Ausgang kann etwa mit einem Lastschütz verbunden sein, welcher den Verbraucher bei längerem festgestelltem Stillstand von der Stromversorgung trennt oder mit einer Kommunikationsschnittstelle, mithilfe derer ein Befehl zum Herunterfahren des Verbrauchers ausgegeben werden kann. Auch weitere Stellbefehle können seitens des Steuergeräts gegeben werden, insbesondere für solche Parameter, welche von außen vorgegeben werden können.

Für derartige Kommunikationsschnittstellen gibt es wiederum zahlreiche Möglichkeiten. Es kann insbesondere vorgesehen sein, dass die Mikroprozessoreinheit über wenigstens eine Kommunikationsschnittstelle, insbesondere drahtgebunden über eine USB-Schnittstelle, eine RS485-Schnittstelle, eine RS232-Schnittstelle, eine Ethernet-Schnittstelle, eine I/O-Link-Schnittstelle oder drahtlos über eine Wireless LAN-Schnittstelle oder Bluetooth, insbesondere Bluetooth Low Energy, mit dem Verbraucher datenverbunden ist. Prinzipiell ist aber jede drahtgebundene oder drahtlose Kommunikationsschnittstelle einsetzbar, welche für beide Seiten zugänglich ist.

Mit besonderem Vorteil können die Mikroprozessoreinheit, das wenigstens eine Interface und die Schnittstellen in einem gemeinsamen Gehäuse aufgenommen sein. Dies erleichtert den Vorgang der Installation des Steuergeräts. Das Steuergerät kann mit seinem Interface und den zugehörigen Schnittstellen insbesondere in einem Industriegehäuse, etwa zur Hutschienenmontage, aufgenommen sein. Dies ermöglicht eine einfache Montage in einem Schaltschrank und somit in direkter Umgebung der Leitungen eines möglichen Verbrauchers. Die Sensoren, welche über die Schnittstellen des Interface angesteuert werden, werden einfach per Kabelverbinder eingesteckt und stehen anschließend zur Verfügung. Auch dies spricht für die Möglichkeit das Steuergerät ohne erheblichen Personalaufwand in Betrieb zu nehmen und schnell positive Effekte damit zu erzielen.

Das erfindungsgemäße Verfahren kann insbesondere vorsehen, dass der Verbraucher mit der Mikroprozessoreinheit datenverbunden ist und dieser Daten über einen Betriebszustand und/oder eine Betriebsphase des Verbrauchers übermittelt, wobei die Mikroprozessoreinheit die Daten über den Betriebszustand und mithilfe der Sensoren erfasste Daten auswertet und mithilfe der Aktoren Maßnahmen zur Verbrauchsreduzierung ergreift. Konkret stehen dem Mikroprozessor alle Messdaten und anderweitig bereitgestellten Informationen zur Verfügung, um diese einerseits zu sammeln, andererseits jedoch auch in Abhängigkeit von der Betriebsphase korrigierend einzugreifen. Wird etwa anhand eines Einsatzplans festgestellt, dass ein Verbraucher sich zu einem Zeitpunkt in der Produktion eines Werkstücks befinden sollte, fließen ihm aber aufgrund der Sensordaten keine Betriebsmittel wie Strom, Kühlwasser oder Material zu, so kann nach einer entsprechenden Zeit entweder ein geordnetes Herunterfahren durch entsprechenden Stillsetzbefehl eine vollständige Abschaltung über einen Lastschütz erfolgen, welcher über einen der schaltbaren Ausgänge betätigt wird.

Ferner kann vorgesehen sein, dass die Mikroprozessoreinheit Daten über den Betriebszustand und/oder eine Betriebsphase des Verbrauchers anhand von mithilfe der Sensoren erfasster Daten ermittelt und mithilfe der Aktoren Maßnahmen zur Verbrauchsreduzierung ergreift. Zunächst ist es möglich, den Betriebszustand aufgrund der von der Mikroprozessoreinheit ermittelten Werte abzuleiten. So kann ein bestimmtes Strom- oder Spannungsprofil, ein Bedarf an Hydrauliköl oder Druckluft ein Indikator dafür sein, dass der Verbraucher sich in einem bestimmten Arbeitsvorgang oder in einer Ruhephase befindet. In Abhängigkeit hiervon können Parameter verändert oder Maßnahmen vorgeschlagen und umgesetzt werden. Gerade in erkennbaren Ruhephasen kann der Verbrauch dadurch reduziert werden, dass Betriebsmittel nicht mehr bereitgestellt werden, soweit auf diese verzichtet werden kann. So kann es sinnvoll sein, in einer Ruhephase den Strombedarf zu reduzieren, indem der Verbraucher in einen Standby-Zustand versetzt wird. Die Versorgung etwa mit Kühlmittel kann jedoch auch in einer Ruhephase weiterhin notwendig sein.

Bevorzugtermaßen kann jedoch auch die Mikroprozessoreinheit mit dem Verbraucher datenverbunden sein und an diesen in Abhängigkeit von dem durch die Auswerteeinheit berechneten Energieverbrauch Steuerbefehle an den Verbraucher übermitteln. Soweit in dem Verbraucher entsprechende Statusnachrichten vorgesehen sind, ist es sinnvoll, diese auch von der Mikroprozessoreinheit einsehen zu lassen, so dass eventuelle Vorgaben leicht eingehalten werden können.

Bei der Erfassung von Messwerten kann je nach Verbraucher die Häufigkeit der Datenerfassung durch die Sensoren einstellbar sein. Hierdurch kann auf die Erfordernisse für die Reaktionsgeschwindigkeit eingegangen werden. Handelt es sich um einen Verbraucher mit kurzfristig veränderlichen Parametern, so kann dies kürzere Abstände zwischen den Abfragen erfordern, bei schwerfälligeren Prozessen können die Abfragezeiträume größer werden.

Die vorstehend beschriebene Erfindung wird im Folgenden anhand eines Ausführungsbeispiels näher erläutert.

Es zeigen
- Figur 1: ein erfindungsgemäßes Steuergerät, welches mit einem Verbraucher verbunden ist, im Hinblick auf eine Auswertung der Stromversorgung in schematischer Darstellung,
- Figur 2: das Steuergerät gemäß Figur 1 im Hinblick auf eine Auswertung der Kühlmittelversorgung in schematischer Darstellung , sowie
- Figur 3: das Steuergerät gemäß Figur 1 im Hinblick auf eine direkte Kommunikation mit dem Verbraucher.

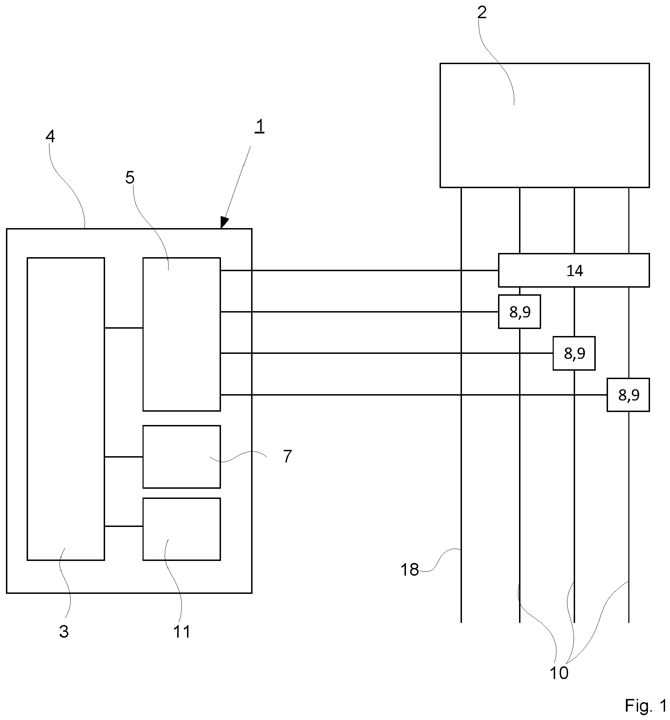

Figur 1 zeigt ein Steuergerät 1, welches einen Verbraucher 2 überwachen soll. Bei dem Verbraucher 2 kann es sich beispielsweise um eine Spritzgießmaschine handeln, zu der ein CO₂-Footprint ermittelt werden soll und welche im Hinblick auf diesen zu optimieren ist. Der Verbraucher 2 ist mithilfe von Stromleitungen 10 mit elektrischem Strom versorgt. Bei den Strom leitungen 10 handelt es sich um drei Phasenleitungen, daneben ist ein Nullleiter 18 vorhanden. Eine Erdleitung ist nicht gezeichnet.

Mithilfe des Steuergeräts 1 soll eine Überwachung des Verbrauchers 2 erfolgen. Hierzu umfasst das Steuergerät 1 einen Mikroprozessor 3, welcher auf ein Interface 5 zurückgreifen kann. An diesem Interface 5 sind zunächst vier Strommesszangen als elektrische Messspulen 9 angeschlossen. Diese dienen als Sensor 8, mit dem der Stromfluss in den Stromleitungen 10 erfasst werden kann. Darüber hinaus kann die Spannungsversorgung des Steuergeräts 1 durch einen Abgriff von Strom an den Strom leitungen 10 erfolgen, was etwa an den Einspeiseklemmen des Verbrauchers 2 oder über einen T-Verbinder erfolgen kann. Hierdurch kann eine eigene Spannungsversorgung des Steuergeräts entfallen.

Durch ein Abschalten des Verbrauchers 2 wird dessen Stromverbrauch beendet. Da der Aktor 14 jedoch oberhalb der hier nicht gezeichneten Einspeiseklemmen liegt, bleibt das Steuergerät 1 einsatzbereit und kann auch das Wiederanfahren des Verbrauchers 2 auslösen, beispielsweise nach Ablauf einer bestimmten Zeit oder zu einem vorher festgelegten Zeitpunkt. Während einer Betriebsphase des Verbrauchers 2, wobei es sich etwa um das Hochfahren oder einen Produktionszyklus handelt, um eine Ruhephase im Leerlauf, einen Reinigungszyklus oder das Herunterfahren, erfasst eine Mikroprozessoreinheit 3 in dem Steuergerät 1 den an den Sensoren 8 anliegenden Strom mithilfe eines Interface 5 und zeichnet die Messwerte auf. Weitere Messwerte wie die Spannung, sowie bei mehreren Leitern eine Scheinleistung, eine Blindleistung und eine Wirkleistung sowie der Phasenwinkel können ebenfalls ermittelt werden. Qualitativ kann auf verschiedene Arten festgestellt werden, in welcher Art von Betriebsphase sich der Verbraucher 2 befindet, nämlich aufgrund des Stromverbrauchs, welcher über die Zeit aufgezeichnet und mit Vergleichsmustern aus einem Speicher 7 der Mikroprozessoreinheit 3 verglichen wird. In Abhängigkeit von einem ermittelten Betriebszustand des Verbrauchers 2 können darüber hinaus Einstellungen vorgenommen werden, welche den CO₂-Footprint des Verbrauchers verbessert.

Eine einfache Möglichkeit des Eingriffs besteht darin, dass den Stromleitungen 10 ein Aktor 14 zugeordnet ist, welcher etwa als Lastschütz ausgestaltet sein kann. Das Interface 5 kann, sobald anhand des Stromverbrauchs etwa eine Ruhephase des Verbrauchers 2 ermittelt wird, diesen über den Aktor 14 abschalten, indem er die Stromleitungen 10 auftrennt und damit den weiteren Stromfluss verhindert.

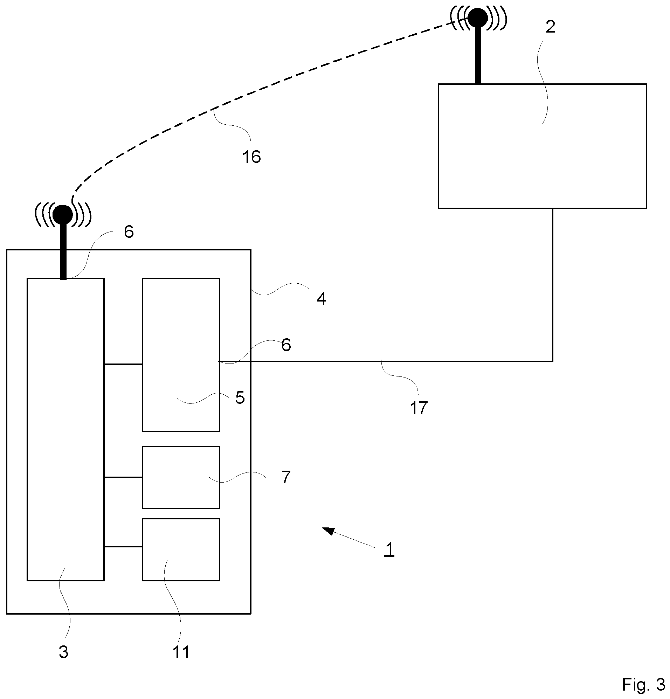

Es kann jedoch auch über die in Figur 3 dargestellten Kommunikationsschnittstellen 6 mit dem Verbraucher drahtlos oder drahtgebunden kommuniziert werden, so dass weitere Informationen zur Verfügung stehen können. Diese können insbesondere Planungsabläufe darstellen, also Zeitpläne, wann der Verbraucher 2 in jedem Fall wieder zur Verfügung stehen muss.

Drahtgebundene Kommunikation wird bevorzugt über eine I/O-Link-Schnittstelle vorgenommen, jedoch sind prinzipiell beliebige Kommunikationsmedien einsetzbar, wie etwa serielle oder parallele Schnittstellen, Ethernet oder dergleichen. Im Rahmen einer drahtlosen Kommunikation ist besonders Bluetooth, bevorzugt Bluetooth Low Energy, oder auch hier ein übliches Wireless Local Area Network, im Einsatz. Eine Einbindung nicht nur in einer direkten Kommunikation mit dem Verbraucher 2, sondern auch mit einem Produktionsleitstand oder weiterer Infrastruktur vor Ort ist sinnvoll möglich.

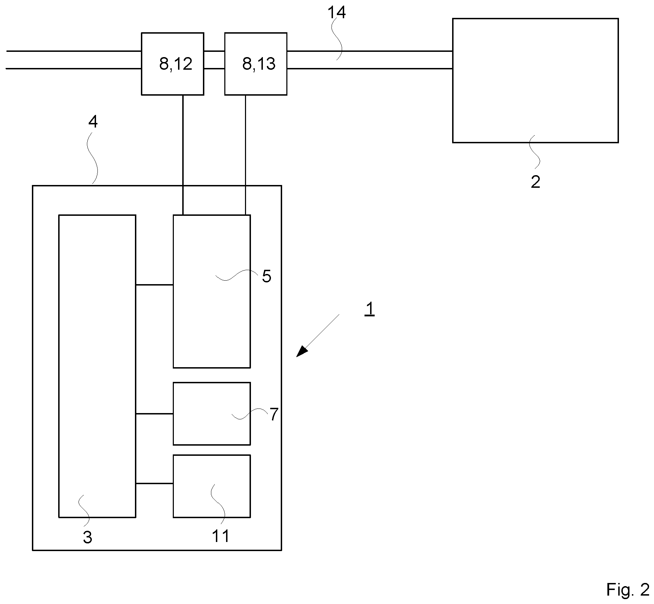

Figur 2 zeigt eine weitere Möglichkeit, um zusätzliche Messdaten zu erhalten, um auf den Betriebszustand des Verbrauchers 2 zurückzuschließen und den CO₂-Footprint zu ermitteln. Hierbei handelt es sich um weitere Sensoren 8, welche in einer Kühlwasserleitung 15 angeordnet sind. Mithilfe eines Kühlwassersensors 12 kann ein Fluss durch die Kühlwasserleitung 15 erfasst werden, so dass die Menge an verbrauchtem Kühlwasser erfasst werden kann. Mithilfe eines Temperatursensors 13 kann ferner die Temperatur des Kühlwassers ermittelt werden. Anhand der Temperatur des von dem Verbraucher 2 zurückfließenden Kühlwassers kann in gewissem Rahmen ebenfalls auf dessen Betriebszustand zurückgeschlossen werden.

Die genannten Sensoren 8 und Aktoren 14 sind lediglich stellvertretend für eine ganze Reihe weiterer Komponenten aufgezählt. Weitere Sensoren 8 und Aktoren 14 für unterschiedliche Messungen können jedoch über das Interface 5 ergänzt werden.

Aus den aufgezeichneten Messwerten ermittelt letztlich eine Auswerteeinheit 11, welche der Mikroprozessoreinheit 3 ebenfalls zugeordnet ist, welche CO₂-Emission den verwendeten Betriebsmitteln entspricht. Aufgrund der zahlreichen verschiedenen Sensoren, welche eingesetzt werden können, ist es möglich, zahlreiche Aspekte der Produktion in einem Verbraucher 2 zu berücksichtigen. Hieraus ergibt sich letztlich der CO₂-Footprint, welcher dem jeweiligen Produkt oder auch dem Verbraucher 2 als solchem, zuzuordnen ist.

Vorstehend beschrieben ist somit ein Steuergerät und ein Verfahren zur Überwachung eines Verbrauchers und zur Ermittlung eines CO₂-Footprints, mit denen eine umfassende Ermittlung verschiedener einzubeziehender Parameter ebenso möglich ist, wie eine Einwirkung zur Optimierung des CO₂-Footprints. Dies ist insbesondere auch mit wenig Aufwand an ungeschultem Personal möglich.

### BEZUGSZEICHENLISTE

- 1: Steuergerät
- 2: Verbraucher
- 3: Mikroprozessoreinheit
- 4: Gehäuse
- 5: Interface
- 6: Kommunikationsschnittstelle
- 7: Speicher
- 8: Sensor
- 9: Elektrische Messspule
- 10: Stromleitungen
- 11: Auswerteeinheit
- 12: Kühlwassersensor
- 13: Temperatursensor
- 14: Aktor
- 15: Kühlwasserleitung
- 16: drahtlose Übertragung
- 17: drahtgebundene Übertragung
- 18: Nullleiter

## Patentansprüche

1. Steuergerät zur Überwachung eines Verbrauchers (2) und zur Ermittlung eines CO₂-Footprints, umfassend eine Mikroprozessoreinheit (3) zur Erfassung und Verarbeitung von Messdaten, welche mit wenigstens einem Interface (5) datenverbunden ist, wobei das Interface (5) mehrere Schnittstellen zur Erhebung von Messdaten aufweist, welche mit dem Verbraucher (2) verbindbar sind und welche Sensoren (8) zur qualitativen und quantitativen Erfassung eines Energieverbrauchs des Verbrauchers (2), sowie Aktoren (14) zur Einwirkung auf den Energieverbrauch des Verbrauchers (2) aufweisen, und wobei der Mikroprozessoreinheit (3) eine Auswerteeinheit (11) zur Berechnung eines Energieverbrauchs während einer Betriebsphase des Verbrauchers (2) zugeordnet ist.

2. Steuergerät gemäß Anspruch 1, **dadurch gekennzeichnet, dass** die Sensoren (8) wenigstens eine elektrische Messspule (9) umfassen, welche an eine Stromleitung (10) des Verbrauchers (2) anschließbar ist und mit welcher Ströme und/oder Spannungen und/oder eine Netzfrequenz und/oder eine Leistung und/oder eine Blindleistung und/oder eine Scheinleistung und/oder eine Phasenverschiebung und/oder aus diesen abgeleitete Größen erfasst sind.

3. Steuergerät gemäß Anspruch 2, **dadurch gekennzeichnet, dass** über ein Netzteil eine Stromversorgung hergestellt ist, wobei die Stromquelle eine Anschlussklemme des Verbrauchers (2) ist.

4. Steuergerät gemäß einem der vorhergehenden Ansprüche, **dadurch gekennzeichnet, dass** die Sensoren (8) wenigstens einen Druckluftsensor (8) umfassen, welcher in eine Druckluftleitung des Verbrauchers (2) aufgenommen ist und welcher einen Durchfluss und/oder einen Druck und/oder eine Temperatur von in der Druckluftleitung geführter Druckluft erfasst.

5. Steuergerät gemäß einem der vorhergehenden Ansprüchen, **dadurch gekennzeichnet, dass** die Sensoren (8) wenigstens einen Temperatursensor (13) umfassen, welcher im Bereich oder in Kontakt mit dem Verbraucher (2) angeordnet ist.

6. Steuergerät gemäß einem der vorhergehenden Ansprüche, **dadurch gekennzeichnet, dass** die Sensoren (8) wenigstens einen Kühlwassersensor (12) umfassen, welcher in eine Kühlwasserleitung (15) des Verbrauchers (2) aufgenommen ist und welcher einen Durchfluss und/oder eine Temperatur von in der Kühlwasserleitung (15) geführtem Kühlwasser erfasst.

7. Steuergerät gemäß einem der vorhergehenden Ansprüche, **dadurch gekennzeichnet, dass** die Sensoren (8) wenigstens einen Füllstandssensor (8) umfassen, welcher einem Medienbehälter des Verbrauchers (2) zugeordnet ist.

8. Steuergerät gemäß einem der vorhergehenden Ansprüche, **dadurch gekennzeichnet, dass** die Aktoren (14) mit schaltbaren Ausgängen des Interface (5) verbunden sind, wobei eine Abschaltung des Verbrauchers in Reaktion auf eine Berechnung eines Energieverbrauchs oder in Reaktion auf eine Feststellung eines Verbrauchsverhaltens des Verbrauchers (2) ausgelöst ist.

9. Steuergerät gemäß einem der vorhergehenden Ansprüche, **dadurch gekennzeichnet, dass** die Mikroprozessoreinheit (3) über wenigstens eine Kommunikationsschnittstelle (6), insbesondere drahtgebunden über eine USB-Schnittstelle, eine RS485-Schnittstelle, eine RS232-Schnittstelle, eine Ethernet-Schnittstelle, eine I/O-Link-Schnittstelle oder drahtlos über eine Wireless LAN-Schnittstelle oder Bluetooth, insbesondere Bluetooth Low Energy, mit dem Verbraucher (2) datenverbunden ist.

10. Steuergerät gemäß einem der vorhergehenden Ansprüche, **dadurch gekennzeichnet, dass** die Mikroprozessoreinheit (3), das wenigstens eine Interface (5) und die Schnittstellen in einem gemeinsamen Gehäuse (4) aufgenommen sind.

11. Verfahren zur Überwachung eines Verbrauchers (2) und zur Ermittlung eines CO₂-Footprints, vermittels eines Steuergeräts (1) mit einer Mikroprozessoreinheit (3), welche Messdaten erfasst und verarbeitet, welche von wenigstens einem mit der Mikroprozessoreinheit (3) datenverbundenen Interface (5) bereitgestellt werden, wobei das Interface (5) mehrere Schnittstellen aufweist, welche über Sensoren (8) und Aktoren (14) mit dem Verbraucher (2) verbunden werden, die Sensoren (8) einen Energieverbrauch des Verbrauchers (2) qualitativ und quantitativ erfassen und die Aktoren (14) auf den Energieverbrauch des Verbrauchers (2) einwirken und wobei die Mikroprozessoreinheit (3) anhand von den Sensoren (8) erfasster Daten mithilfe einer Auswerteeinheit (11) einen Energieverbrauch während einer Betriebsphase des Verbrauchers (2) berechnet.

12. Verfahren gemäß Anspruch 11, **dadurch gekennzeichnet, dass** der Verbraucher (2) mit der Mikroprozessoreinheit (3) datenverbunden ist und dieser Daten über einen Betriebszustand und/oder eine Betriebsphase des Verbrauchers (2) übermittelt, wobei die Mikroprozessoreinheit (3) die Daten über den Betriebszustand und mithilfe der Sensoren (8) erfasste Daten auswertet und mithilfe der Aktoren (14) Maßnahmen zur Verbrauchsreduzierung ergreift.

13. Verfahren gemäß Anspruch 11, **dadurch gekennzeichnet, dass** die Mikroprozessoreinheit (3) Daten über den Betriebszustand und/oder eine Betriebsphase des Verbrauchers (2) anhand von mithilfe der Sensoren (8) erfasster Daten ermittelt und mithilfe der Aktoren (14) Maßnahmen zur Verbrauchsreduzierung ergreift.

14. Verfahren gemäß einem der Ansprüche 11 bis 13, **dadurch gekennzeichnet, dass** die Mikroprozessoreinheit (3) mit dem Verbraucher (2) datenverbunden ist und an diesen in Abhängigkeit von dem durch die Auswerteeinheit (11) berechneten Energieverbrauch Steuerbefehle an den Verbraucher (2) übermittelt.

15. Verfahren gemäß einem der Ansprüche 11 bis 14, **dadurch gekennzeichnet, dass** die Häufigkeit der Datenerfassung durch die Sensoren (8) einstellbar ist.

## Geänderte Patentansprüche

### Geänderte Patentansprüche gemäss Regel 137(2) EPÜ.

1. Steuergerät zur Überwachung eines Verbrauchers (2) und zur Ermittlung einer CO₂-Emmission, umfassend eine Mikroprozessoreinheit (3) zur Erfassung und Verarbeitung von Messdaten sowie wenigstens ein Interface (5), wobei die Mikroprozessoreinheit (3) mit dem wenigstens einem Interface (5) datenverbunden ist, wobei das Interface (5) mehrere Schnittstellen zur Erhebung von Messdaten aufweist, welche mit dem Verbraucher (2) verbindbar sind und welche Sensoren (8) zur qualitativen und quantitativen Erfassung eines Energieverbrauchs des Verbrauchers (2), sowie Aktoren (14) zur Einwirkung auf den Energieverbrauch des Verbrauchers (2) aufweisen,
**dadurch gekennzeichnet, dass** der Mikroprozessoreinheit (3) eine Auswerteeinheit (11) zur Berechnung eines Energieverbrauchs während einer Betriebsphase des Verbrauchers (2) zugeordnet ist, wobei die Aktoren (14) mit schaltbaren Ausgängen des Interface (5) verbunden sind, wobei eine Abschaltung des Verbrauchers in Reaktion auf eine Berechnung eines Energieverbrauchs oder in Reaktion auf eine Feststellung eines Verbrauchsverhaltens des Verbrauchers (2) ausgelöst ist.

2. Steuergerät gemäß Anspruch 1, **dadurch gekennzeichnet, dass** die Sensoren (8) wenigstens eine elektrische Messspule (9) umfassen, welche an eine Stromleitung (10) des Verbrauchers (2) anschließbar ist und mit welcher Ströme und/oder Spannungen und/oder eine Netzfrequenz und/oder eine Leistung und/oder eine Blindleistung und/oder eine Scheinleistung und/oder eine Phasenverschiebung und/oder aus diesen abgeleitete Größen erfasst sind.

3. Steuergerät gemäß einem der vorhergehenden Ansprüche, **dadurch gekennzeichnet, dass** die Sensoren (8) wenigstens einen Druckluftsensor (8) umfassen, welcher in eine Druckluftleitung des Verbrauchers (2) aufgenommen ist und welcher einen Durchfluss und/oder einen Druck und/oder eine Temperatur von in der Druckluftleitung geführter Druckluft erfasst.

4. Steuergerät gemäß einem der vorhergehenden Ansprüchen, **dadurch gekennzeichnet, dass** die Sensoren (8) wenigstens einen Temperatursensor (13) umfassen, welcher im Bereich oder in Kontakt mit dem Verbraucher (2) angeordnet ist.

5. Steuergerät gemäß einem der vorhergehenden Ansprüche, **dadurch gekennzeichnet, dass** die Sensoren (8) wenigstens einen Kühlwassersensor (12) umfassen, welcher in eine Kühlwasserleitung (15) des Verbrauchers (2) aufgenommen ist und welcher einen Durchfluss und/oder eine Temperatur von in der Kühlwasserleitung (15) geführtem Kühlwasser erfasst.

6. Steuergerät gemäß einem der vorhergehenden Ansprüche, **dadurch gekennzeichnet, dass** die Sensoren (8) wenigstens einen Füllstandssensor (8) umfassen, welcher einem Medienbehälter des Verbrauchers (2) zugeordnet ist.

7. Steuergerät gemäß einem der vorhergehenden Ansprüche, **dadurch gekennzeichnet, dass** die Mikroprozessoreinheit (3) über wenigstens eine Kommunikationsschnittstelle (6), insbesondere drahtgebunden über eine USB-Schnittstelle, eine RS485-Schnittstelle, eine RS232-Schnittstelle, eine Ethernet-Schnittstelle, eine I/O-Link-Schnittstelle oder drahtlos über eine Wireless LAN-Schnittstelle oder Bluetooth, insbesondere Bluetooth Low Energy, mit dem Verbraucher (2) datenverbunden ist.

8. Steuergerät gemäß einem der vorhergehenden Ansprüche, **dadurch gekennzeichnet, dass** die Mikroprozessoreinheit (3), das wenigstens eine Interface (5) und die Schnittstellen in einem gemeinsamen Gehäuse (4) aufgenommen sind.

9. Verfahren zur Überwachung eines Verbrauchers (2) und zur Ermittlung einer CO₂-Emmision, vermittels eines Steuergeräts (1) mit einer Mikroprozessoreinheit (3) und wenigstens einem Interface (5), wobei die Mikroprozessoreinheit (3) Messdaten erfasst und verarbeitet, welche von dem wenigstens einem mit der Mikroprozessoreinheit (3) datenverbundenen Interface (5) bereitgestellt werden, wobei das Interface (5) mehrere Schnittstellen aufweist, welche über Sensoren (8) und Aktoren (14) mit dem Verbraucher (2) verbunden werden, die Sensoren (8) einen Energieverbrauch des Verbrauchers (2) qualitativ und quantitativ erfassen und die Aktoren (14) auf den Energieverbrauch des Verbrauchers (2) einwirken und wobei die Mikroprozessoreinheit (3) anhand von den Sensoren (8) erfasster Daten mithilfe einer Auswerteeinheit (11) einen Energieverbrauch während einer Betriebsphase des Verbrauchers (2) berechnet,
**dadurch gekennzeichnet, dass** der Verbraucher (2) mit der Mikroprozessoreinheit (3) datenverbunden ist und dieser Daten über einen Betriebszustand und/oder eine Betriebsphase des Verbrauchers (2) übermittelt, wobei die Mikroprozessoreinheit (3) die Daten über den Betriebszustand und mithilfe der Sensoren (8) erfasste Daten auswertet und mithilfe der Aktoren (14) Maßnahmen zur Verbrauchsreduzierung ergreift, wobei bei Ermittlung einer Ruhephase des Verbrauchers (2) der Verbraucher (2) über die Aktoren (14) abgeschaltet wird.

10. Verfahren zur Überwachung eines Verbrauchers (2) und zur Ermittlung einer CO₂-Emmision, vermittels eines Steuergeräts (1) mit einer Mikroprozessoreinheit (3) und wenigstens einem Interface (5), wobei die Mikroprozessoreinheit (3) Messdaten erfasst und verarbeitet, welche von dem wenigstens einen mit der Mikroprozessoreinheit (3) datenverbundenen Interface (5) bereitgestellt werden, wobei das Interface (5) mehrere Schnittstellen aufweist, welche über Sensoren (8) und Aktoren (14) mit dem Verbraucher (2) verbunden werden, die Sensoren (8) einen Energieverbrauch des Verbrauchers (2) qualitativ und quantitativ erfassen und die Aktoren (14) auf den Energieverbrauch des Verbrauchers (2) einwirken und wobei die Mikroprozessoreinheit (3) anhand von den Sensoren (8) erfasster Daten mithilfe einer Auswerteeinheit (11) einen Energieverbrauch während einer Betriebsphase des Verbrauchers (2) berechnet,
**dadurch gekennzeichnet, dass** die Mikroprozessoreinheit (3) Daten über den Betriebszustand und/oder eine Betriebsphase des Verbrauchers (2) anhand von mithilfe der Sensoren (8) erfasster Daten ermittelt und mithilfe der Aktoren (14) Maßnahmen zur Verbrauchsreduzierung ergreift, wobei bei Ermittlung einer Ruhephase des Verbrauchers (2) der Verbraucher (2) über die Aktoren (14) abgeschaltet wird.

11. Verfahren gemäß Anspruch 9 oder 10, **dadurch gekennzeichnet, dass** die Mikroprozessoreinheit (3) mit dem Verbraucher (2) datenverbunden ist und an diesen in Abhängigkeit von dem durch die Auswerteeinheit (11) berechneten Energieverbrauch Steuerbefehle an den Verbraucher (2) übermittelt.

12. Verfahren gemäß einem der Ansprüche 9 bis 11, **dadurch gekennzeichnet, dass** die Häufigkeit der Datenerfassung durch die Sensoren (8) einstellbar ist.
